Europäisches Patentamt

European Patent Office

Office européen des brevets

(11) Publication number: **0 227 398**
A1

## (12) EUROPEAN PATENT APPLICATION

(21) Application number: 86309743.2

(22) Date of filing: 15.12.86

(51) Int. Cl.⁴: **H 05 K 7/10**

(30) Priority: 17.12.85 US 810276

(43) Date of publication of application:
01.07.87 Bulletin 87/27

(84) Designated Contracting States:
AT BE CH DE ES FR GB GR IT LI LU NL SE

(71) Applicant: Ouellette, Alan
Post Office Box 24464
Minneapolis Minesota 55424(US)

(72) Inventor: Ouellette, Alan
Post Office Box 24464
Minneapolis Minesota 55424(US)

(74) Representative: Turner, Paul Malcolm
URQUHART DYKES & LORD 91 Wimpole Street
London W1M 8AH(GB)

(54) Improved electronic circuit microelement and base assembly.

(57) An improved electronic circuit microelement and base
assembly comprises a conventional microelement 10 with a
body of insulating material and a separate parallel series of
terminals 16, 16 all projecting in the same direction. The base
20 is of insulating material and has a plurality of recesses 22,
22 each holding a rear portion 30 of a connector 32 en-
gageable with a terminal. The microelement 10 is mounted
on a top surface 18 of the base 20, its terminal 16, 16 entering
the recesses 22, 22 and engaging their respective connectors
32. The connectors 32 have portions projecting upwardly
about the microelement body 10 for ready engagement and
connection with experimental or other wiring, all wiring
being readily effective from one side of the assembly unit
without reversal or "flip flopping" of the assembly.

FIG. I

# IMPROVED ELECTRONIC CIRCUIT MICROELEMENT AND BASE ASSEMBLY

## BACKGROUND OF THE INVENTION

This invention relates to the mounting of electronic circuit microelements on circuit boards and other surfaces. More particularly, the invention relates to an electronic circuit microelement and base assembly wherein electrical connections can be readily made both between the terminals of an electronic circuit microelement and externally thereof, all on one side of a circuit board and without passage of the terminals of the microelement or associated connectors through the circuit board.

A conventional electronic circuit microelement comprises a simple rectangular parallelepiped of insulating material encapsulating the active circuit elements of the microelement. To connect the integrated circuit elements within the component to an external circuit, or to interconnect such elements, a plurality of electrical leads are provided through the nonconductive encapsulation or body of the microelement. The leads, conventionally projecting from a pair of opposite sides of the

-1-

body of the microelement, extend outwardly and are bent through approximately 90° a short distance after leaving the nonconductive encapsulation or body such that all leads or terminals have free end portions extending parallel to each other. Thus, a pair of rows or first and second spaced parallel series of terminal free end portions extend a substantial distance from the body of the element in the same direction.

Microelements so constructed are usually mounted directly to circuit boards by inserting terminals, pins or leads in corresponding female sockets and the terminals may project through the boards or connectors engaged by the terminals may project through the boards. The opposite surface of the circuit board may of course include a printed circuit, and especially in experimental activities, there may be connectors which project from an opposite side of the circuit board and which are associated with the terminals of the microelement for selective interconnection and for selective external electrical connection by means of small insulated wires. That is, the connectors may be interconnected so as to interconnect their respective terminals and internal circuit elements by means of small insulated wires and/or the connectors may be employed with small diameter insulated wire to effect connections externally with other circuit elements.

Particularly in the case of experimental activities involving the use of small diameter insulated wire and wherein there may be a degree of "cut and dry" technique involved, the circuit board must be continuously reversed so that the operator can properly associate the terminals of the microelement with the connectors which project from the opposite side of the circuit board. Not only is the continuous reversal or "flip flopping" of the circuit board inconvenient and inefficient in experimental activities, but it will be apparent that errors tend to creep into the experimental wiring as a result of such an awkward technique.

It is the general object of the present invention to provide an assembly of an electronic circuit microelement and a base wherein connectors are provided with exposed free end portions adjacent the body of the microelement and readily accessible on one side of the assembly, the need for reversal or "flip flopping" of a circuit board thus being wholly elminated.

## SUMMARY OF THE INVENTION

In fulfillment of the foregoing object and in accordance with the present invention, an electronic circuit microelement is provided and has a body of insulating material and a plurality of similar electrically conductive terminals which extend from opposite sides of the body. Each of the terminals is bent so that all terminals project in the same direction with two spaced apart parallel series of terminals. Each terminal has a free end portion adapted to make electrical contact and is preferably of a narrow flat configuration adapted to make contact at opposite flat surfaces thereof. The base for mounting the microelement for selective external electrical connection and electrical interconnection of its terminals is constructed of insulating material and has a plurality of electrically conductive connectors at least partially exposed at one surface thereof.

The connectors are engageable in electrically conductive contact with the free end portions of the terminals of the microelement when the body of the microelement is positioned on said one said surface of the base with the terminals projecting toward the base. The exposed portions of the connectors are accessible for electrical connection adjacent the surface of the base on which the microelement is located and, preferably, said connectors have free end portions projecting beyond the body of the microelement with narrow slots therein for self-stripping action on engagement of small diameter insulated electrical wire therewith. Thus, experimental and other wiring may be readily accomplished involving the interconnection of connectors and their associated terminals and the connection of the terminals via the connectors with external circuit elements.

Preferably, the terminals and the connectors are adapted for firm frictional interengagement so as to provide for the establishment and maintenance of good electrical contact therebetween and also to retain the body of the microelement in position on the said one surface of the base.

## BRIEF DESCRIPTION OF THE DRAWINGS

Fig. 1 is an exploded view in perspective showing the assembly comprising the electronic circuit microelement and the base therefore with its parts including a top plate and a main body portion and electrically conductive connectors.

Fig. 2 is a perspective view showing the assembly of the electronic circuit microelement and its base.

Fig. 3 is a vertical section taken generally as indicated at 3, 3 in Fig. 2.

## DESCRIPTION OF PREFERRED EMBODIMENT

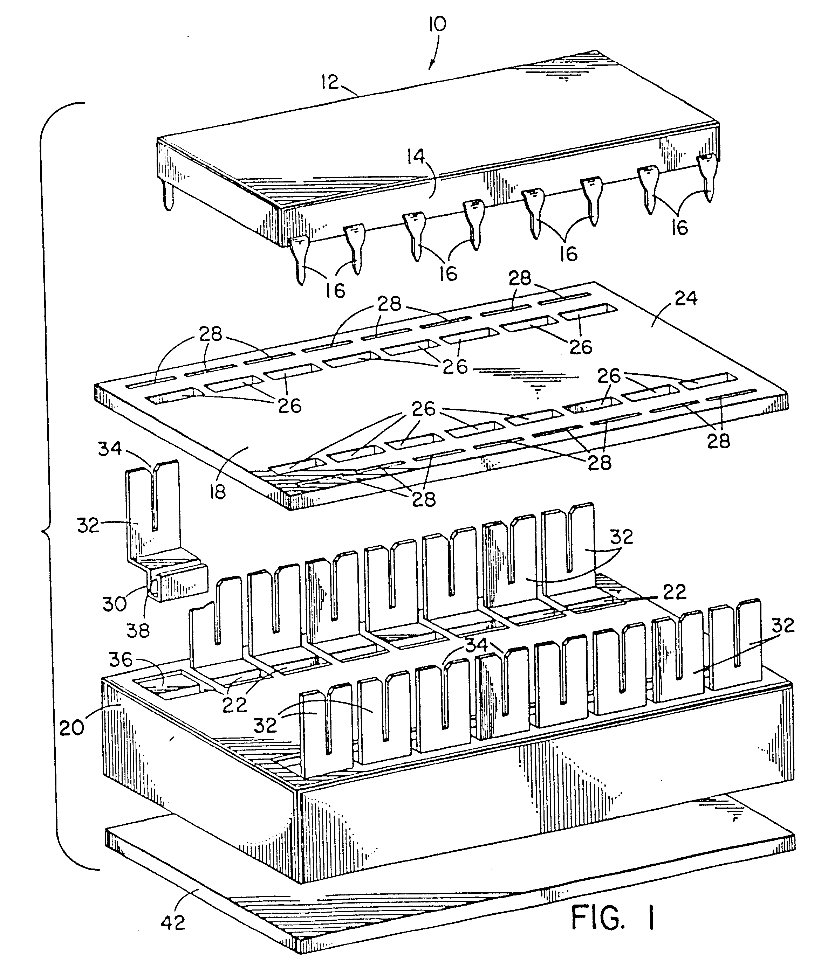

Referring particularly to Fig. 1, it will be observed that a microelement indicated generally at 10 takes the form of a simple rectangular parallelepiped with a body of insulating material. A pair of opposite sides thereof 12, 14, the longer sides in Fig. 1, each has leads or terminals projecting therefrom. The leads or terminals 16, 16 are shown projecting through the sides of the body of the microelement 10 in opposite directions and bent through approximately 90 . Thus, as best illustrated in Figs. 1 and 3, the leads or terminals 16, 16 extend in the same direction and form two spaced apart parallel series of terminals. Each terminal is shown as having a relatively broad base with a narrower free end portion and, more particularly, each terminal may optionally have a V-shaped free end portion. The terminals are preferably of a flat construction with opposite flat surfaces thereof being preferably engageable for good electrical contact. As is well known, the active circuit elements within the body 10 of the microelement may be connected by means of the leads or terminals 16, 16. That is, the terminals may be interconnected or connections may be effected between the terminals and external circuit elements.

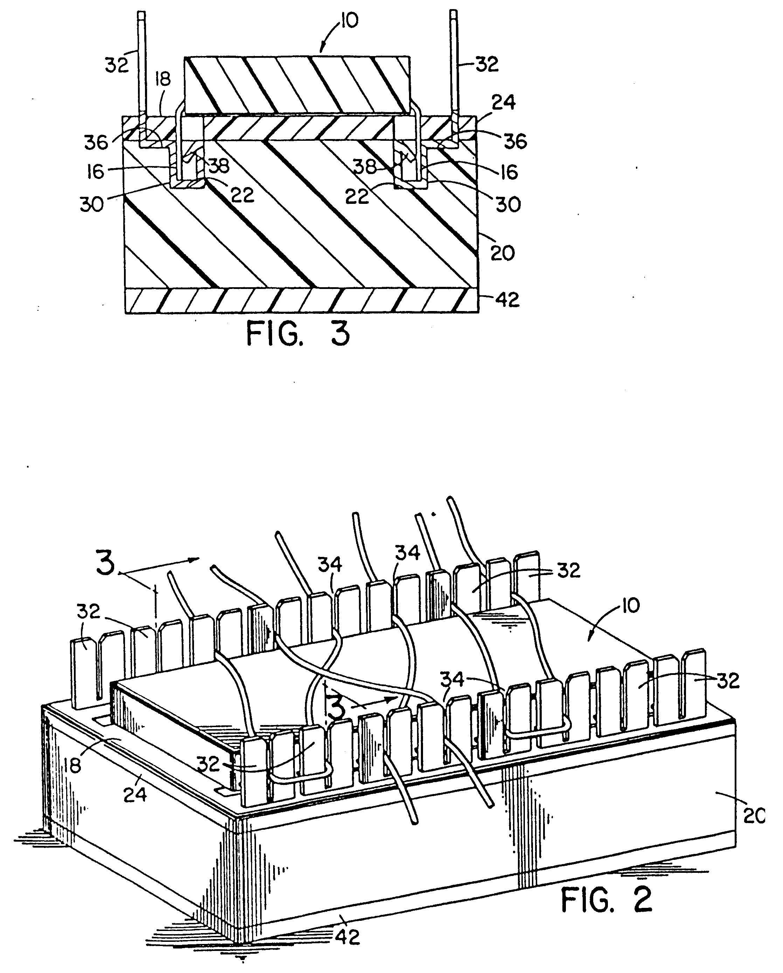

Referring now to Fig. 2, it will be observed that the microelement 10 is disposed on an upper flat surface 18 of a base 20 and is in flat engagement with said upper or one surface of the base 20. The microelement 10, as shown in Fig. 2, has its terminal 16, 16 projecting downwardly therefrom and, as best illustrated in Fig. 3, the said terminals are entered in recesses 22, 22 formed in the main or body portion 20 of the base. The base is preferably formed in two parts with a top plate 24 which may be adhesively or otherwise mounted on and above the main body portion 20 and which defines the aforementioned one or top surface 18 on which the microelement 10 is mounted.

As best illustrated in Fig. 1, the top plate 24 is provided with two rows or a series of openings 26, 26 which are in parallel and spaced apart relationship and which respectively receive the terminals 16, 16 in downward passage therethrough when the microelement 10 is disposed on the surface 18 atop the plate 24. Thus, the terminals 16, 16 in projecting downwardly through the openings 26, 26 enter the recesses 22, 22 in the main

-6-

or body portion 20 of the base. A second row of slots 28, 28 has each slot disposed outwardly of an associated slot in the rows or series of slots 26, 26. As shown, there are eight (8) slots 26 in each row and eight (8) slots 28 in each row with an equal number of terminals 16, 16 for entry in the slots 26, 26.

Referring again to Fig. 3 it will be observed that each of the recesses 22, 22 receives a lower or rear end portion 30 of a connector 32 with the said rear end portion of the connector being held in position by the lower surface of the top plate 24. That is, with the rear end portion of the connectors entered in the recesses 22, 22 and with the portions 32, 32 projecting upwardly through the slots 28, 28 in the top plate, the portion of the plate 24 between the slots 26, 28 serves to retain the connectors in position. Shoulders or seats 36, 36 formed on the base member 20 serve to support portions of the connectors 32, 32 and the top plate 24 engages upper portions of the connectors opposite the seats 36, 36 to hold the connectors in position as illustrated.

As will be observed, foward or upper portions of the connectors 32, 32 are in exposed positions and are readily accessible for making electrical connections thereto. Preferably and as illustrated, each forward or upper portion of a connector 32, is provided with a narrow slot as illustrated at 34, 34. Each of the slots 34, 34 has a narrow upwardly or forwardly projecting mouth which is slightly widened and the slots may be readily employed in connecting small diameter insulated wire as illustrated in Fig. 2. That is, wire entered downwardly in the slots 34, 34 engages the connectors 32, 32 in a self-stripping operation and the wire may of course be employed in interconnecting connectors and their associated terminals or in effecting connection of the connectors and their associated terminals with external circuit components.

Preferably and as shown, rear portions 30, 30 of the connectors are bent back upon themselves in generally U-shaped configurations and each such connector portion is provided with a small tang 38. Each of the tangs 38, 38 is preferably inclined across its associated recess 22 rearwardly or downwardly relative to the mouth of the recess. Thus, the tang defines with an opposing wall of the rear end portion 30 of the connector a narrow slot which is of a lesser dimension than the thickness of an associated terminal 16. Accordingly, when a free end portion of a terminal 16 is urged downwardly or rearwardly into a recess 22 as illustrated in Fig. 3, the tang 38 is bent slightly downwardly and remains in firm frictional engagement with the terminal 16. The downward flexing of the tang 38 urges the terminal 16 into firm frictional and electrical contact with the opposing wall portion of the rear end portion 30 of the connector and good electrical contact is achieved on opposite flat surfaces of the terminal 16 with both the wall portion and the tang in engagement therewith. The frictional engagement of the rear portion of the connector including the tang 38 and the wall portion with the terminal free end portion is such as to maintain the necessary firm electrical contact and also to securely retain the microelement 10 in position atop the base 20.

The base 20 is preferably also provided with an adhesive means opposite its top plate and a separate adhesive carrying base plate is illustrated at 42. The base plate 42 may be provided with an adhesive means on its under surface and may of course be employed in securing the base and the assembled microelement on a circuit board or any other flat surface.

Referring now to the manufacture and assembly of the base parts, it will be apparent in Fig. 1 that the connectors 32, 32 may be readily disposed in the recesses 22, 22 in the base body portion whereupon a top plate 24 may be lowered into position thereabove with the upper connector portions projecting upwardly through the slots 28, 28 with the top plate secured in position as by means of an adhesive connection or other connecting means, the base may thereafter be employed in mounting and effecting electrical connections for various microelements as in the case of the microelement 10. A base plate 42 may of course be adhesively or otherwise connected to the base body 20 and similarly adhesively connected to a printed circuit board etc.

As will be apparent from the foregoing, the connector forward or upper free end portions are exposed and extend upwardly beyond the microelement 10.  Thus, as best illustrated in Fig. 2, experimental or other wiring may be readily and coveniently accomplished and the operator may view indicia on the microelement 10 while effecting the necessary connections between connectors 32, 32 and their associated terminals 16, 16.  Such connections may be readily changed during experimentation.  It is wholly unecessary to reverse or "flip flop" a circuit board in order to first view a microelement and its terminals and/or indicia thereon and thereafter to effect the desired connections between connectors residing on an opposite side of the circuit board but operatively associated with the various terminals.

## C L A I M S

1. An assembly comprising an electronic circuit microelement having a body of insulating material housing active circuit components and a plurality of similar electrically conductive terminals which extend from opposite sides of the body, each of said terminals being bent so that the terminals project in two spaced apart parallel series and in the same direction, and each terminal having a free end portion adapted to make electrical contact, a base for mounting the microelement for selective external electrical connection and for electrical interconnection of its terminals, said base being of insulating material and having a plurality of electrically conductive connectors at least partially exposed at one surface thereof, said connectors being engageable in electrically conductive contact with said free end portions of said terminals on said microelement when the body of the microelement is positioned on said one surface of said base with the terminals projecting toward the base, and said exposed portions of said connectors being accessible for electrical connection adjacent the surface of said base on which said microelement is located.

2. An assembly comprising an electronic circuit microelement and a base therefore as set forth in claim 1 wherein the terminals on the microelement and the connectors of the base are adapted for firm frictional interengagement so as to provide for the establishment and maintenance of good electrical contact therebetween.

-11-

3.     An assembly comprising an electronic circuit microelement and a base therefore as set forth in claim 2 wherein the frictional engagement between the terminals and conductors serves to maintain the body of the microelement in position as described on said one surface of the base.

4.     An assembly comprising an electronic circuit microelement and a base therefore as set forth in claim 2 wherein recesses are provided in one surface of said base, and wherein said connectors are provided with rear end portions which are received and secured respectively in said recesses and which have forward and free end portions projecting therefrom and from said one surface, and wherein said terminal free end portions project into said recesses and frictionally engage said rear end portions of said connectors as aforesaid when said body of said microelement is positioned on said one surface of said base.

5.     An assembly comprising an electronic circuit microelement and a base therefore as set forth in claim 4 wherein said projecting forward and free end portions of said connectors extend beyond the body of said microelement for ready electrical connection thereto when the body portion of the microelement is positioned on said one surface of said base as aforesaid.

6.     An assembly comprising an electronic circuit microelement and a base therefore as set forth in claim 5 wherein each of said connectors at its forward and free end portion is provided with a narrow slot which opens forwardly and which is adapted to receive a portion of an insulated electrically conductive wire in a self-stripping insertion of the wire and the slot.

7.     An assembly comprising an electronic circuit microelement and a base therefore as set forth in claim 4 wherein each of said connectors has a small flexible tang at its rear end portion which is bendable slightly when engaged by the free end portion of a corresponding terminal and which thereafter tends to return to its free condition whereby to remain in firm frictional engagement with the terminal free end portion.

8.     An assembly comprising an electronic circuit microelement and a base therefore as set forth in claim 7 wherein said small tang at a rear end portion of each connector is inclined at an angle extending across and slightly away from the mouth of its associated recess so as to engage and tend to prevent withdrawal of a free end portion of an associated terminal.

0227398

9. An assembly comprising an electronic circuit microelement and a base therefore as set forth in claim 8 wherein each of said terminals has a narrow flat free end portion adapted to make electrical contact at opposite flat surfaces thereof, and wherein a rear end portion of each of said connectors is bent back upon itself in a generally U-shaped configuration so as to define an entry slot between the end of its tang and a spaced but adjacent wall surface thereof, the entry slot being narrower than the thickness of the free end portion of an associated terminal with the tang in a free condition so that the tang is bent rearwardly on entry of the free end portion of the terminal and frictionally engages the same with one flat surface of the terminal engaging the tang and the opposite flat surface thereof engaging said wall.

10. An assembly comprising an electronic circuit microelement and a base therefore as set forth in claim 8 wherein said base is constructed in two parts with a main body and a top plate, the main body having recesses therein for receiving rear end portions of connectors and the top plate having openings therethrough which are in alignment with the recesses with the top plate assembled to the base for the forward projection of the free end portions of the connectors therethrough, the top surface of the top plate forming said one surface of the base, and the opposite and lower surface of said top plate serving to secure said rear end portions of said connectors in the recesses of said main body portion of the base.

-14-

11.     An assembly comprising an electronic circuit microelement and a base therefore as set forth in claim 10 wherein an adhesive mounting means is provided on said base on a surface thereof opposite said one surface.

0227398

FIG. I

FIG. 3

FIG. 2

**European Patent Office**

## EUROPEAN SEARCH REPORT

EP 86 30 9743

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | US-A-4 460 236 (M.G. STRAUTZ)<br><br>* column 1, lines 53-66; column 2, lines 35-53; the figure * | 1-4,7, 8 | H 05 K 7/10 |
| A | * idem * | 9 | |
| X | US-A-4 478 476 (E.R. JONES)<br>* column 1, lines 54-64; figures 1-2 * | 1-4 | |
| A | * idem * | 9 | |
| X | DE-B-1 765 657 (AMP)<br>* column 2, lines 27-30; figure 1 * | 1-3 | TECHNICAL FIELDS SEARCHED (Int. Cl.4)<br><br>H 05 K 7/00 |
| A | * idem * | 4,5 | |
| A | DE-A-2 724 235 (MINNESOTA MINING AND MANUFACTURING CO.)<br>* page 5, lines 1-4, 21 - page 6, line 4; page 7, lines 11-25; page 10, lines 19-23; figures 1-2 * | 6 | |

The present search report has been drawn up for all claims

| Place of search | Date of completion of the search | Examiner |
|---|---|---|
| BERLIN | 04-03-1987 | LEOUFFRE M. |